(19) Europäisches Patentamt
European Patent Office
Office européen des brevets

(11) **EP 4 016 282 B1**

(12) **EUROPEAN PATENT SPECIFICATION**

(45) Date of publication and mention
of the grant of the patent:
**28.01.2026 Bulletin 2026/05**

(21) Application number: **20214385.5**

(22) Date of filing: **15.12.2020**

(51) International Patent Classification (IPC):
***G06F 7/58*** *(2006.01)*

(52) Cooperative Patent Classification (CPC):
**G06F 7/588**

(54) **QRNG CHIP MASS PRODUCTION METHOD**

VERFAHREN ZUR MASSENHERSTELLUNG VON QRNG-CHIPS

PROCÉDÉ DE PRODUCTION EN MASSE DE PUCE QRNG

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**22.06.2022 Bulletin 2022/25**

(73) Proprietor: **ID Quantique S.A.**
**1227 Genève (CH)**

(72) Inventors:
• **KIM, Hyoungill**
**Gyeonggi-do (KR)**
• **YOON, Pilsang**
**Gyeonggi-do (KR)**
• **HAN, Kyoungbok**
**Gyeonggi-do (KR)**

(74) Representative: **KATZAROV S.A.**
**Geneva Business Center**
**12 Avenue des Morgines**
**1213 Petit-Lancy (CH)**

(56) References cited:
**US-A1- 2016 170 856     US-A1- 2018 277 198**
**US-A1- 2019 250 890**

# EP 4 016 282 B1

**Description**

**Technical Field**

The present invention relates to a method for QRNG Chip Mass Production, more particularly for producing QRNG Chips in mass within a short period of time.

**Background of the art**

In general, the present invention is in the context of the generation of random numbers and more particularly in the context of the manufacturing methods of RNG. Many tasks in modern science and technology make use of random numbers, including simulation, statistical sampling, gaming applications, and cryptography, both classical and quantum. A good random number generator should produce a chain of bits with high entropy at a high rate. By high entropy, it is meant that nobody can predict the value of the bit before the bit is revealed, entropy can also be understood as randomness. This is an essential requirement in most of the modern cryptographic algorithms and protocols. Indeed, all the cryptography protocols commonly employed, such as DSA-, RSA- and Diffie-Hellman-algorithms, follow Kerckhoffs' principle, which dates back to the 19th century, and states that the security of a cypher must reside entirely in the key, i.e. in the random sequence used as seed, which is fully unpredictable. It is therefore of particular importance that the key used in a cryptographic algorithm is secure, which in practice requires it to be chosen perfectly at random, i.e. randomly generated.

In order to be able to generate such a random sequence, the QRNG comprises achieve controlling it to perform such random number generation.

US 2016/170856 A1 discloses an example for testing hardware in view of its random number generation performance.

These chips are produced in mass and, of course, inspections are necessary to evaluate the functionality and performance of each produced chip. In particular, the evaluation of is carried out through different tests among which a test which is called the Final Test (FT) that is extremely important as it is the last test performed on the chips, which determines if a chip can or not be introduced into the market.

In fact, based on the results of the FT, only the produced chips classified as a good chips can be shipped into market.

In general, the entire inspection time should be as short as possible in order to reduce the ocupation time of the production equipment related closely in test cost and in order to increase the production capacity. Normally the whole test time should take a few dozens of seconds per chip.

In general, the entropy generated from all kinds of random number generator shall follow the specifications as those defined in standard like the ones of National Institute of Standards and Technology (NIST)or British Standards Institution (BSI) etc.

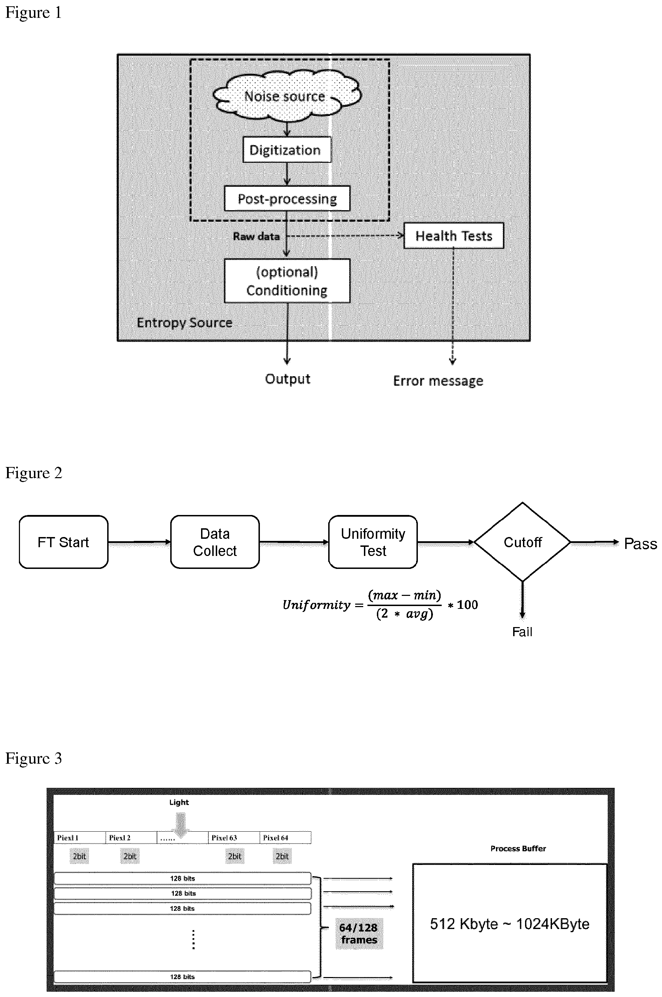

Figure 1 shows the entropy source model in NIST SP800-90B.

In NIST SP800-90B, there are two kinds of test, the IID, which permits to check a collection of random variables and come from Iindependent and Identically Distributed, and the non-IID test. These tests allow to evaluate the quality of the entropy of the chip embedded in an RNG, also usually called "Randomness".

Some users request that the non-IID test results are performed with very long RNG sample length, i.e. the testes sequence should be more than 10MB, as this indicate a measure of the performance of the produced entropy source.

Typically, it takes a long time to perform all the test cases defined in non-IID test, as these are 17 different test cases. In addition, it also takes time to generate and test long data samples. As an example, in NIST, a test case requires 1 to 2 hours, therefore, for mass production where 10,000 chips are produced, 10,000 to 20,000 hours test should be requires.

Therefore, according to prior art, there is no typical way of valuably inspect/evaluate the quality of entropy source in mass production.

As most of the RNGs are aimed at providing random numbers as a final output, a typical way of evaluating the quality of their random numbers is based on Federal Information Processing Standards (FIPS).

However, recently QRNGs have been designed for providing not random numbers but an entropy source. It is thus necessary to have a new method for testing the quality of their entropy source.

As an example, in NIST SP800-90B, the non-IID test consists of 17 test cases, where in order to evaluate the performance of entropy source, a "Randomness" test is performed. In fact. many viable noise sources fail to produce IID outputs. Therefore, for non-IID data, the estimators below shall be calculated on the outputs of the noise source and outputs of any conditioning component, and the minimum of all the estimates is taken as the entropy assessment of the entropy source for this Recommendation tests.

Non-IID test:

- H-bit = min (MCV bit, Collision., Markov bit, Compression, T-Tuple bit, LRS bit, Multi-MCW bit, Lag bit, Multi Markov bit, LZ78Y bit)
- H-org = min (MCV org, T-Tuple org, LRS org, Multi MCW org, Lag org, Multi Markov org, LZ78Y org)

The above estimators are the Most Common Value estimate, the Collision Estimate, the Markov Estimate, the Compression Estimate, *the t-*Tuple Estimate, the Longest Repeated Substring (LRS) Estimate, the Multi Most Common in Window Prediction Estimate, the Lag Prediction Estimate, the MultiMMC Prediction Estimate, and The LZ78Y Prediction Estimate

From this test, a Final Minimum entropy is derived where the Final Minimum Entropy ranges from 0 (Low/poor) to 1 (high/best):

- H-min = min (H-bit, H-org/8)

The below shows the example of test results:

| ChipId | Iteratic | H MIN | H org | H bit | Uniformi | MCV b | MCV or | Colisio | Marko | Compressic | T-Tuple b | T-Tuple or |
|---|---|---|---|---|---|---|---|---|---|---|---|---|
| 9C110B43122B | 10 | 0.93595225 | 7.487618 | 0.946431 | 0.481 | 0.998655 | 7.941446 | 1 | 0.997568 | 0.949432 | 0.946431 | 7.746975 |

| LZ78Y o | LZ78Y b | Multi Markov on | Multi Markov b | Lag org | Lag bi | Multi MCW o | Multi MCW b | LRS org | LRS bi |
|---|---|---|---|---|---|---|---|---|---|
| 7.985537 | 0.997178 | 7.985539 | 0.997248 | 7.982175 | 0.999484 | 7.487618 | 0.999782 | 7.965082 | 0.955151 |

where the ChipId is the Identity of the tested Chip and the Iteration is the number of test time.

However, as mentioned before, those kinds of test cases are not suitable in FT process for mass production because of the time limitation.

There is therefore a need for such an entropy source evaluation/inspecting method permitting to be adapted to mass production in order to reduce the test time.

It is therefore the object of the present invention to dramatically reduce the test time of mass production RNGs.

In this regard, a primary object of the invention is to solve the above-mentioned problems and more particularly to provide a random number generation chip production method comprising an entropy source testing method reducing the overall test time so as to be adapted to mass production.

### Summary of the invention

The solution to the time reduction objective of the present invention is obtained by reducing the test data length and by improving the accuracy of the tests. In particular, the present invention uses a block uniformity method, which only tests part of sample data, called the block, outputted by one chip instead of the whole data sequence. Typically, the tested part has a length of from 512KB to 1024KB instead of the 10MB mentioned before.

This block uniformity method can be repeated for each single chips in production, in order to evaluate if such chip is good or not.

In addition to this block uniformity method, when the sample data is not long enough, the fluctuation of the block uniformity becomes big and to cope with such fluctuation an alternative or complementary method is proposed which is called the pixel uniformity method.

A first aspect of the invention relates to a RNG Chip testing method comprising a test start-up phase starting a Final Test phase, a data collection step wherein frames of bit sequences having a length of 1024 KB, preferably 512 KB generated by the RNG chip are collected, a uniformity determining step comprising calculating the uniformity of the bit sequence according the following formula:

$$Uniformity = \frac{(max - min)}{(2 * avg)} * 100$$

a comparison step where the determined uniformity is compared to a predetermined threshold, and a judging step judging whether the chip has passed or failed the test based on the result of the comparison step.

Preferably, the RNG Chip testing method further comprises a chip sample management step consisting in discarding the chip sample in case of failing the test.

Advantageously, the data collection step comprises collecting frames of bit sequences having a length of 1024 KB, preferably 512 KB for each of 64 pixels of a chip.

According to a preferred embodiment of the invention, the uniformity determining step comprising calculating the uniformity of all 64 pixels independently and the average uniformity of all 64 pixels.

Advantageously, the comparison step compares the average uniformity of all 64 pixels to a predetermined threshold and discard the chip of the average uniformity is lower than said threshold.

According to a preferred embodiment of the invention, the RNG Chip testing method further comprises a peak uniformity measurement step calculating the minimum/maximum peak value for each pixel.

Preferably, the RNG Chip testing method further comprises a compensation step to be run for the chips which have passed the comparison step only, wherein the peak uniformity of each pixel is checked.

According to a preferred embodiment of the invention, the judging step judges that either all the pixel of the chip have passed the compensation step and the chip is considered as a good sample or at least one pixel of the chip fails the compensation step and the chip is considered as a bad sample and considered as to be discarded.

A second aspect of the invention relates to a RNG chip manufacturing method comprising the RNG Chip testing method of the first aspect of the invention

Preferably, the RNG chip manufacturing method is involved in a mass manufacturing process.

A third aspect of the invention relates to a Random Number Generator comprising a chip manufactured by the RNG chip manufacturing method of the second aspect of the invention.

### Brief description of the drawings

Further particular advantages and features of the invention will become more apparent from the following non-limitative description of at least one embodiment of the invention which will refer to the accompanying drawings, wherein

- Figure 1 represents the entropy source model in NIST SP800-90B;
- Figure 2 schematically represents the sequence of the Final Test process using the block uniformity method of the present invention;
- Figure 3 schematically represent the data collection for the block uniformity method of the present invention;
- Figure 4 schematically represents an example of the block uniformity method results;
- Figure 5 schematically represents the sequence of the Final Test process using the pixel uniformity method of the present invention;
- Figure 6 schematically represent data collection from each pixel for pixel uniformity method of the present invention.

**Detailed description of the invention**

The present detailed description is intended to illustrate the invention in a non-limitative manner since any feature of an embodiment may be combined with any other feature of a different embodiment in an advantageous manner.

Figure 2 shows the first aspect of the invention which is a method for calculating the uniformity in a QRNG chip. According to this method which is called the block uniformity method, data from a tested RNG or QRNG shall be collected, as shown in figure 3, with a certain length from a CMOS Image Sensor pixel. Here the term RNG shall define any type of Random Number Generator including Quantum random Number Generator or the like. Also, the Term RNG here may independently refer to the RNG as a whole or the RNG chip according to the context.

As explained above, in real scenarios, when it comes to mass production, it is impossible - due to time constraints - to execute the full non-IID tests in order to classify whether or not a sample is good and can be introduced into the market.

For this reason, the present invention relates to a RNG chip testing method comprising the steps of starting the Final test, then collecting data, preferably frames of bit sequences having a length of 1024 KB, preferably 512 KB. The RNG chip testing method comprises a block uniformity step as shown in figure 2 which solves the technical problem calculating the uniformity of the bit sequence outputted by the RNG according to the following formula:

$$Uniformity = \frac{(max - min)}{(2 * avg)} * 100$$

The Uniformity therefore indicates how evenly distributed data in bit units and this formula is applied such that, considering that 1 pixel has 2bits and present 4 kinds of output "00", "01","10","11". For example, among 400 pixel data,"00" shows 101 times; "01" shows 103 times, "10" shows 97 times, "11" shows: 99 then the above forumla is applied as follows :

$$uniformity = (103-97)/(2x100) \times 100 = 3 \%$$

The calculated uniformity shows how much gathered data spread out uniformly in a dynamic range. This feature is basic requirement on randomness. A further advantage is that uniformity is easier to apply to classify good sample in mass production. Indeed, in order to verify the chip that provides the entropy source, tests provided by NIST such as Non-iid and Iid described above are performed, but it takes a lot of time and causes a decrease in productivity. So, there are some advantages in mass production.

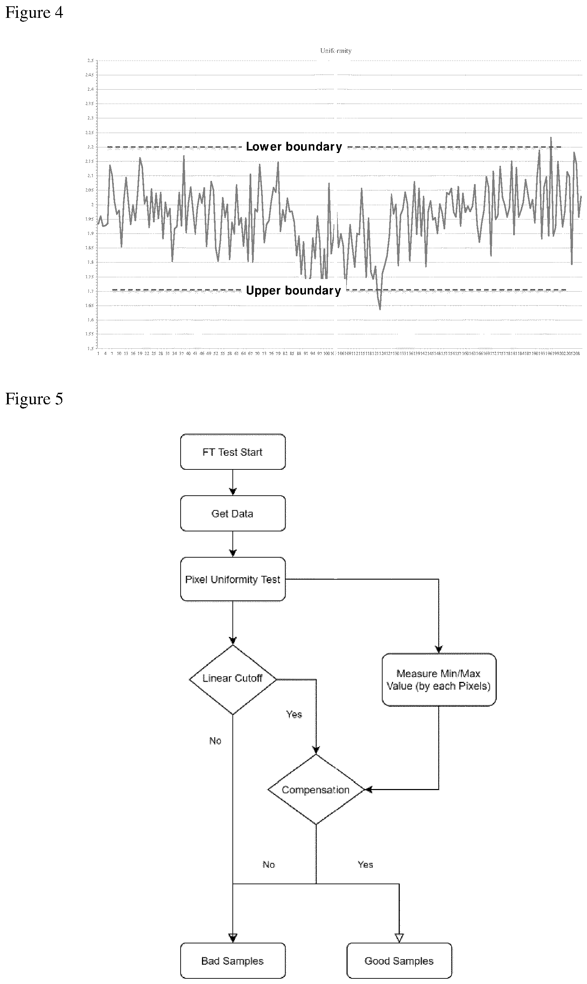

Once the uniformity is calculated, it is compared to a cut-off criteria/value. The cut-off criteria has to be set to an upper value of dynamic range of block uniformity. However, as shown in figure 4, the block uniformity, has a big fluctuation when data length is not enough long.

For this reason, the block uniformity method can show the overall performance of a chip but it lacks precisely showing the performance of each pixel comprised in the chip since one defectious pixel may be hidden by the overall performance.

For this reason, an alternative/complementary testing method has been developed as well, the Pixel Uniformity method which his shown in figure 5.

The principle of the first steps of the Pixel Uniformity method is somehow like the block uniformity method in that it comprises the similar first steps consisting in starting the Final test, then collecting data, preferably frames of bit sequences having a length of 1024 KB, preferably 512 KB. The main difference here resides in the collection step where the frames are collected for each pixel.

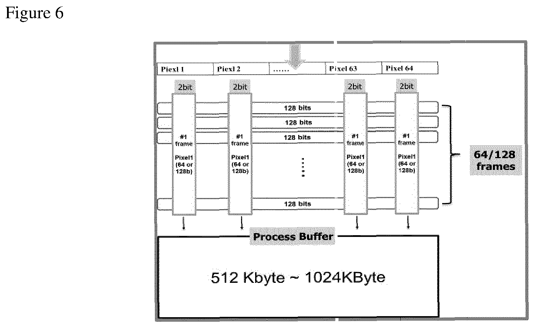

In general, a RNG chip has 64 pixels and this method consists in gathering a frame of bit sequence of 1024 KB, preferably 512 KB, for each pixel according to the figure 6.

After collecting the data, a pixel uniformity test according to the same formula above for the block uniformity test is run for each one of the 64 pixels. Taking into account that each of the 64 pixels have two bits and each bit may be 0, 1, 2 or 3.

Basically, the basic unit of uniformity is calculated as 2 bits, so block uniformity method and pixel uniformity method have the same formula. However, as awe can see from figures 3 and 6, the difference between these methods rather consists in the collection data and whether the data is calculated using the whole data or it is calculated using the data for each pixel unit.

At that point two processes start independently:

- The first one is a linear cut-off step where the average uniformity of all 64 pixels is calculated and compared to a threshold/cut-off criteria/value such that if the average uniformity fails the linear cut-off test, the chip is discarded, and
- The second one is a minimum/maximum peak value measurement for each pixel.

At that point, if the result of the linear cut-off step is positive, i.e. if the average uniformity is acceptable, a compensation step is started where the peak uniformity, i.e. the maximum value among 64 pixel's uniformity, of each pixel is checked. For a 512Kbyte frame, the average cut off is preferably 2.3% and peak uniformity is preferably 10%.

This compensation step permits to prevent the occurrence of dramatic uniformity in a small number of pixels, causing errors in that pixel or significantly affecting the overall performance. For example, if the uniformity of 63 pixels ideally converges to 0, but the uniformity of only one pixel is more than 10, it is not an evenly distributed entropy source. In order to prevent this, the concept of compensation is cut-off with Peak Uniformity.

After the compensation step, either all the pixel of the chip have passed the peak uniformity and the chip is considered as a good sample and considered as acceptable or at least one pixel of the chip fails the peak uniformity and the chip is considered as a bad sample and considered as to be discarded.

The advantage of this method is that since each pixel has its own unique characteristics in terms of electronic feature side, the data extracted from each pixel show smaller fluctuation in uniformity than the block uniformity method. Therefore, when only small data length is available on FT process, pixel uniformity is even more effective than block uniformity in terms of yield/cost/accuracy.

While the embodiments have been described in conjunction with a number of embodiments, it is evident that many alternatives, modifications and variations would be or are apparent to those of ordinary skill in the applicable arts. Accordingly, this disclosure is intended to embrace all such alternatives, modifications, equivalents and variations that are within the scope of this disclosure. This for example particularly the case regarding the system embedding the chip as well as any type of hardware carrying out this method.

**Claims**

1. Random Number Generator, RNG, Chip testing method comprising:

   a test start-up phase starting a Final Test phase,
   a data collection step wherein frames of bit sequences having a length of 1024 KB, preferably 512 KB generated by the RNG chip are collected, wherein the bit sequences comprises multiple bit patterns output by pixels,
   a uniformity determining step comprising calculating the uniformity of the bit sequences according the following formula :

$$Uniformity = \frac{(max - min)}{(2 * avg)} * 100$$

   wherein max is the maximal frequency of a bit pattern in the multiple bit patterns output by the pixels, min is the minimal frequency of a bit pattern in the multiple bit patterns output by the pixels and avg is the average of the frequency of all bit patterns in the multiple bit patterns, a comparison step where the determined uniformity is compared to a predetermined threshold, and
   a judging step judging whether the chip has passed or failed the test based on the result of the comparison step.

2. RNG Chip testing method according to claim 1, **characterized in that** it further comprises a chip sample management step consisting in discarding the chip sample in case of failing the test.

3. RNG Chip testing method to claim 1 or 2, **characterized in that** the data collection step comprises collecting frames of bit sequences having a length of 1024 KB, preferably 512 KB for each of 64 pixels of a chip.

4. RNG Chip testing method according to claim 3, **characterized in that** the uniformity determining step comprising calculating the uniformity of all 64 pixels independently and the average uniformity of all 64 pixels.

5. RNG Chip testing method according to claim 3 or 4, **characterized in that** the comparison step compares the average uniformity of all 64 pixels to a predetermined threshold and discard the chip of the average uniformity is lower than said threshold

6. RNG Chip testing method according to any one of claims 1 to 5, **characterized in that** it further comprises a peak uniformity measurement step calculating the minimum/maximum peak value for each pixel.

7. RNG Chip testing method according to any one of claims 1 to 6, **characterized in that** it further comprises a compensation step to be run for the chips which have passed the comparison step only, wherein the peak uniformity of each pixel is checked.

8. RNG Chip testing method according to claim 7, **characterized in that** the judging step judges that either all the pixel of the chip have passed the compensation step and the chip is considered as a good sample or at least one pixel of the chip fails the compensation step and the chip is considered as a bad sample and considered as to be discarded.

9. RNG chip manufacturing method comprising the RNG Chip testing method of any one of claims 1-8.

10. RNG chip manufacturing method according to claim 9, **characterized in that** it is involved in a mass manufacturing process.

11. Random Number Generator comprising a chip manufactured by the RNG chip manufacturing method according to claim 10.

**Patentansprüche**

1. Testverfahren für einen Zufallszahlengenerator- bzw. RNG-Chip (RNG vom engl. random number generator), wobei das Verfahren umfasst:

   eine Test-Startphase, die eine finale Testphase startet,
   einen Datensammlungsschritt, in dem Frames von Bitsequenzen mit einer Länge von 1024 KB, vorzugsweise 512 KB, die von dem RNG-Chip erzeugt werden, gesammelt werden, wobei die Bitsequenzen mehrere Bitmuster umfassen, die von Pixeln ausgegeben werden,
   einen Gleichverteilungs-Bestimmungsschritt, der das Berechnen der Gleichverteilung der Bitsequenzen in Übereinstimmung mit der folgenden Formel umfasst:

$$Uniformity = \frac{(max - min)}{(2 * avg)} * 100$$

   wobei max die maximale Frequenz eines Bitmusters in den mehreren Bitmustern ist, die von den Pixeln ausgegeben werden, *min* die minimale Frequenz eines Bitmusters in den mehreren Bitmustern ist, die von den Pixeln ausgegeben werden, und *avg* der Durchschnitt der Frequenz aller Bitmuster in den mehreren Bitmustern ist, einen Vergleichsschritt, in dem die bestimmte Gleichverteilung mit einer vorbestimmten Schwelle verglichen wird, und
   einen Beurteilungsschritt, der beurteilt, ob der Chip den Test bestanden oder nicht bestanden hat, auf Grundlage des Ergebnisses des Vergleichsschritts.

2. Testverfahren für einen RNG-Chip nach Anspruch 1, **dadurch gekennzeichnet, dass** es ferner einen Chip-Proben-Managementschritt umfasst, der in dem Verwerfen der Chip-Probe im Fall des Nichtbestehens des Tests besteht.

3. Testverfahren für einen RNG-Chip nach Anspruch 1 oder 2, **dadurch gekennzeichnet, dass** der Datensammlungsschritt das Sammeln von Frames von Bitsequenzen mit einer Länge von 1024 KB, vorzugsweise 512 KB, für jedes von 64 Pixeln eines Chips umfasst.

4. Testverfahren für einen RNG-Chip nach Anspruch 3, **dadurch gekennzeichnet, dass** der Gleichverteilungs-Bestimmungsschritt das Berechnen der Gleichverteilung für alle 64 Pixel unabhängig voneinander sowie der durchschnittlichen Gleichverteilung für alle 64 Pixel umfasst.

5. Testverfahren für einen RNG-Chip nach Anspruch 3 oder 4, **dadurch gekennzeichnet, dass** der Vergleichsschritt die durchschnittliche Gleichverteilung aller 64 Pixel mit einer vorbestimmten Schwelle vergleicht und den Chip verwirft, wenn die durchschnittliche Gleichverteilung niedriger als die Schwelle ist.

6. Testverfahren für einen RNG-Chip nach einem der Ansprüche 1 bis 5, **dadurch gekennzeichnet, dass** es ferner einen Schritt zur Messung der Spitzen-Gleichverteilung umfasst, welcher den minimalen/maximalen Spitzenwert für jedes Pixel berechnet.

7. Testverfahren für einen RNG-Chip nach einem der Ansprüche 1 bis 6, **dadurch gekennzeichnet, dass** es ferner einen Kompensationsschritt umfasst, der für die Chips ausgeführt werden soll, welche nur den Vergleichsschritt bestanden hat haben, wobei die Spitzen-Gleichverteilung für jedes Pixel überprüft wird.

8. Testverfahren für einen RNG-Chip nach Anspruch 7, **dadurch gekennzeichnet, dass** der Beurteilungsschritt beurteilt, dass entweder alle Pixel des Chips den Kompensationsschritt bestanden haben und der Chip als eine gute Probe angesehen wird, oder zumindest ein Pixel des Chips den Kompensationsschritt nicht bestanden hat und der Chip als eine schlechte Probe angesehen wird und als zu verwerfen angesehen wird.

9. Verfahren zur Herstellung eines RNG-Chips, umfassend das Testverfahren für einen RNG-Chip nach einem der Ansprüche 1 - 8.

10. Verfahren zur Herstellung eines RNG-Chips nach Anspruch 9, **dadurch gekennzeichnet, dass** es in ein Massenfertigungsverfahren involviert ist.

11. Zufallszahlengenerator, umfassend einen Chip, der durch das Verfahren zur Herstellung eines RNG-Chips nach Anspruch 10 hergestellt ist.

**Revendications**

1. Méthode de test de puce de générateur de nombres aléatoires (RNG), comprenant

une phase de démarrage du test commençant par une phase de test final,
une étape de collecte de données dans laquelle des trames de séquences de bits d'une longueur de 1024 Kb, de préférence 512 Kb, générées par la puce de RNG sont collectées, les séquences de bits comprenant des motifs de bits multiples émis par des pixels,
une étape de détermination de l'uniformité comprenant un calcul de l'uniformité des séquences de bits selon la formule suivante :

$$Uniformity = \frac{(max - min)}{(2 * avg)} * 100$$

où max est la fréquence maximale d'un motif de bits dans les motifs de bits multiples sortis par les pixels, min est la fréquence minimale d'un motif de bits dans les motifs de bits multiples sortis par les pixels et avg est la moyenne de la fréquence de tous les motifs de bits dans les motifs de bits multiples,
une étape de comparaison dans laquelle l'uniformité déterminée est comparée à un seuil prédéterminé, et
une étape de jugement pour déterminer si la puce a réussi ou échoué le test sur la base du résultat de l'étape de comparaison.

2. Méthode de test de puce de RNG selon la revendication 1, **caractérisée en ce qu'**elle comprend en outre une étape de gestion de l'échantillon de puce consistant à rejeter l'échantillon de puce en cas d'échec du test.

3. Méthode de test de puce de RNG selon la revendication 1 ou 2, **caractérisée par le fait que** l'étape de collecte des données comprend de collecter des trames de séquences de bits d'une longueur de 1024 Kb, de préférence 512 Kb pour chacun des 64 pixels d'une puce.

4. Méthode de test de puce de RNG selon la revendication 3, **caractérisée en ce que** l'étape de détermination de l'uniformité comprend de calculer l'uniformité des 64 pixels indépendamment et l'uniformité moyenne des 64 pixels.

**5.** Méthode de test de puce de RNG selon la revendication 3 ou 4, **caractérisée par le fait que** l'étape de comparaison compare l'uniformité moyenne des 64 pixels à un seuil prédéterminé et rejette la puce dont l'uniformité moyenne est inférieure audit seuil.

**6.** Méthode de test de puce de RNG selon l'une des revendications 1 à 5, **caractérisée en ce qu'**elle comprend en outre une étape de mesure de l'uniformité de crête calculant la valeur de crête minimale/maximale pour chaque pixel.

**7.** Méthode de test de puce de RNG selon l'une des revendications 1 à 6, **caractérisée en ce qu'**elle comprend en outre une étape de compensation à exécuter uniquement pour les puces qui ont passé l'étape de comparaison, dans laquelle l'uniformité de crête de chaque pixel est vérifiée.

**8.** Méthode de test de puce de RNG selon la revendication 7, **caractérisée en ce que** l'étape de jugement estime que soit tous les pixels de la puce ont passé l'étape de compensation et la puce est considérée comme un bon échantillon, soit au moins un pixel de la puce échoue à l'étape de compensation et la puce est considérée comme un mauvais échantillon et doit être éliminée.

**9.** Méthode de fabrication d'une puce de RNG comprenant la méthode de test de puce de RNG de l'une quelconque des revendications 1 à 8.

**10.** Méthode de fabrication d'une puce de RNG selon la revendication 9, **caractérisée par le fait qu'**elle est utilisée dans un processus de fabrication de masse.

**11.** Générateur de nombres aléatoires comprenant une puce fabriquée par la méthode de fabrication de puce de RNG selon la revendication 10.

Figure 1

Figure 2

$$Uniformity = \frac{(max - min)}{(2 * avg)} * 100$$

Figure 3

Figure 4

Figure 5

Figure 6

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2016170856 A1